# EUROPEAN PATENT APPLICATION

(11) **EP 2 743 968 A1**
(43) Date of publication of application: **18.06.2014**
(21) Application number: 12822290.8
(22) Date of filing: 03.08.2012
(51) Int. Cl.: H01L 21/304, B24B 37/00, C09K 3/14

(54) **COMPOSITION FOR POLISHING COMPOUND SEMICONDUCTOR**

(30) Priority: 09.08.2011 JP 2011174372
(71) Applicant: Fujimi Incorporated, Kiyosu-shi, Aichi 452-8502 (JP)
(72) Inventor: ASANO, Hiroshi, Kiyosu-shi Aichi 452-8502 (JP); MORINAGA, Hitoshi, Kiyosu-shi Aichi 452-8502 (JP); TAMAI, Kazusei, Kiyosu-shi Aichi 452-8502 (JP)
(74) Representative: Grünecker, Kinkeldey, Stockmair & Schwanhäusser
(86) International application number: PCT/JP2012/069856
(87) International publication number: WO 2013/021946

(57) **Abstract**

Disclosed is a polishing composition that contains at least abrasive grains, an oxidizing agent having a redox potential equal to or greater than 1.8 V at a pH for application of polishing, and water. The abrasive grains are preferably composed of at least one substance selected from among silicon oxide, aluminum oxide, cerium oxide, zirconium oxide, titanium oxide, manganese oxide, silicon carbide, and silicon nitride. The oxidizing agent is preferably composed of at least one substance selected from among sodium persulfate, potassium persulfate, and ammonium persulfate. The polishing composition preferably has a pH equal to or less than 3.

## Description

### TECHNICAL FIELD

The present invention relates to a polishing composition to be used for polishing an object made of a compound semiconductor material.

### BACKGROUND ART

In recent years, a compound semiconductor has been widely used as a material to be used for manufacturing a power device or a high luminance LED. When a compound semiconductor is used for manufacturing a power device or an LED, surface polishing is typically applied to the compound semiconductor since it is required to obtain a smooth surface having no processing damage.

However, compound semiconductors are generally extremely chemically-stable and have low reactivity, and the polishing process for an extremely hard compound semiconductor thereamong is not easy. Accordingly, a compound semiconductor is normally lapped with diamond and then polished with colloidal silica to remove scratches generated in the lapping process. For example, polishing of a silicon carbide substrate with a polishing composition having a specific pH and containing colloidal silica (see Patent Document 1, for example) and a method for polishing a gallium nitride substrate with a polishing composition having a specific pH and containing amorphous silica and an acid (see Patent Document 2, for example) are known. However, in a case where these polishing compositions are used for polishing a compound semiconductor, it is impossible to obtain a sufficient polishing rate (removal rate). Especially, in a case where a lapped substrate is polished with these polishing compositions, there is a problem that it takes time to obtain a highly smooth surface, which leads to low productivity.

### PRIOR ART DOCUMENTS

Patent Document 1: Japanese Laid-Open Patent Publication No. 2005-117027
Patent Document 2: Japanese Patent No. 4350505

### SUMMARY OF THE INVENTION

### Problems that the Invention is to Solve

Accordingly, it is an objective of the present invention to provide a polishing composition that can polish a compound semiconductor at a high polishing rate.

### Means for Solving the Problems

To achieve the foregoing objective and in accordance with an aspect of the present invention, a polishing composition to be used for polishing a compound semiconductor is provided that contains at least abrasive grains, an oxidizing agent having a redox potential equal to or greater than 1.8 V at a pH at which the polishing is carried out, and water.

The abrasive grains are preferably composed of at least one substance selected from the group consisting of silicon oxide, aluminum oxide, cerium oxide, zirconium oxide, titanium oxide, manganese oxide, silicon carbide, and silicon nitride.

The oxidizing agent is preferably composed of at least one substance selected from the group consisting of sodium persulfate, potassium persulfate, and ammonium persulfate. Alternatively, the oxidizing agent may be a hydroxy radical.

The polishing composition preferably has a pH equal to or less than 3.

In accordance with another aspect of the present invention, a method for preparing the polishing composition according to the above aspect is provided that includes providing a first composition containing abrasive grains and water and a second composition containing an oxidizing agent having a redox potential equal to or greater than 1.8 V and water, and mixing the first composition with the second composition to prepare the polishing composition. Yet another aspect of the present invention provides a polishing method for polishing a compound semiconductor with the polishing composition according to the above aspect, and a manufacturing method of a compound semiconductor including polishing a compound semiconductor using the polishing method.

### Effects of the Invention

According to the present invention, a polishing composition is provided that can polish a compound semiconductor at a high polishing rate. Although the reason why such an effect is obtained with the present invention is not clear, it is considered that breakage of chemical bonds on the compound semiconductor surface is promoted specifically by the action of the oxidizing agent contained in the polishing composition.

### MODES FOR CARRYING OUT THE INVENTION

Hereinafter, an embodiment of the present invention will be described.

A polishing composition according to the present embodiment contains at least abrasive grains, an oxidizing agent, and water. The polishing composition is used for polishing an object made of a compound semiconductor material, i.e., a compound semiconductor and is further used for manufacturing a compound semiconductor and more precisely a semiconductor device by polishing such an object.

Although various kinds of compound semiconductors, such as IV compound semiconductors, III-V semiconductors, and II-VI semiconductors, are known, the polishing composition of the present embodiment is used for polishing hard compound semiconductors thereamong having a Vickers hardness equal to or greater than 1,500 Hv and more specifically carbide semiconductors, such as silicon carbide (SiC), or nitride semiconductors, such as gallium nitride (GaN) and aluminum nitride (AlN). The compound semiconductor may be made of a mixed crystal, i.e., a composite compound.

Among them, a preferable object to be polished is a compound semiconductor containing silicon and carbon or a compound semiconductor containing gallium and nitrogen, and SiC or GaN is especially preferable.

The oxidizing agent contained in the polishing composition of the present embodiment acts on a compound semiconductor surface and functions to break or cut a chemical bond on the surface. Although various kinds of oxidizing agents, such as persulfates, perchlorates, periodates, and permanganates, are generally known in addition to peroxides, such as hydrogen peroxide, an oxidizing agent to be used for the polishing composition of the present embodiment is an oxidizing agent having a redox potential equal to or greater than 1.8 V and preferably equal to or greater than 2.0 V at a pH for application of polishing, or, in other words, the same pH as that of the polishing composition and more precisely the same pH as that of the polishing composition during use thereof for polishing. An oxidizing agent having a redox potential equal to or greater than 1.8 V has a sufficient effect of cutting a chemical bond on a compound semiconductor surface, which enables effective polishing of a compound semiconductor with the polishing composition. Specific examples of an oxidizing agent having a redox potential equal to or greater than 1.8 V include a persulfate. The redox potential of an oxidizing agent can be calculated with the Nernst equation by using the value of standard redox potential of the oxidizing agent measured on the basis of a normal hydrogen electrode (NHE) together with the value of pH of the polishing composition as necessary.

A preferable oxidizing agent thereamong is sodium persulfate, potassium persulfate, and ammonium persulfate. A persulfate is also referred to as peroxosulfate, and an oxidizing agent to be used may be either peroxomonosulfate or peroxodisulfate, or may include both. Since a persulfate has a sufficient redox potential to break a chemical bond on a compound semiconductor surface, it is possible to obtain a preferable polishing rate in polishing of a compound semiconductor with the polishing composition when a persulfate is used as an oxidizing agent.

The polishing composition may contain, instead of an oxidizing agent, a substance that can generate a hydroxy radical. In other words, a substance that functions as an oxidizing agent in the polishing composition may be a hydroxy radical rather than a persulfate. Examples of a substance that can generate a hydroxy radical include hydrogen peroxide. Hydrogen peroxide generates a hydroxy radical by catalytic action of metal that can have different valences, such as Cr, Cu, Fe, Mn, Ni, Ti, and V, or of an organic substance. Since a hydroxy radical has a sufficient redox potential to break a chemical bond on a compound semiconductor surface, it is possible to obtain a preferable polishing rate in polishing of a compound semiconductor with the polishing composition also in a case where a hydroxy radical functions as an oxidizing agent.

Meanwhile, it is preferable that the polishing composition contains as an oxidizing agent any one of sodium persulfate, potassium persulfate, and ammonium persulfate to avoid an adverse effect on the performance of a semiconductor device by metal contamination and to improve the stability of the polishing composition.

The oxidizing agent content in the polishing composition is preferably equal to or greater than 0.05% by mass and more preferably equal to or greater than 0.2% by mass. The oxidizing agent content in the polishing composition is also preferably equal to or less than 20% by mass and more preferably equal to or less than 5% by mass. When the oxidizing agent content is appropriate, the polishing rate of an object (compound semiconductor) with the polishing composition is more suitably improved.

The abrasive grains contained in the polishing composition are preferably silicon oxide, aluminum oxide, cerium oxide, zirconium oxide, titanium oxide, manganese oxide, silicon carbide, or silicon nitride. Especially preferable abrasive grains are silicon oxide, particularly colloidal silica or fumed silica and more preferably colloidal silica. When such abrasive grains are used, it is possible to obtain a smoother and more satisfactory surface on a compound semiconductor after polishing with the polishing composition.

Surface-modified abrasive grains may be used. Surface modification of abrasive grains is performed, for example, by attaching or bonding a substance having a potential different from that of an abrasive grain surface, to the abrasive grain surface so as to change the potential of the abrasive grain surface. Although there is no limitation on a substance to be used for changing the potential of an abrasive grain surface, a surfactant, an inorganic acid, an organic acid, or a metal oxide, such as aluminum oxide, may be used in a case where the abrasive grains are silicon oxide.

The average secondary particle diameter (volume mean diameter D50) of the abrasive grains contained in the polishing composition is preferably equal to or greater than 0.005 µm and more preferably equal to or greater than 0.02 µm. As the average secondary particle diameter of the abrasive grains becomes greater, the polishing rate of an object with a polishing composition is improved.

The average secondary particle diameter of the abrasive grains contained in the polishing composition is preferably equal to or less than 5 µm and more preferably equal to or less than 0.2 µm. As the average secondary particle diameter of the abrasive grains becomes less, it is easy to obtain a low-defect and small-roughness surface on an object after polishing with the polishing composition. Measurement of the average secondary particle diameter of the abrasive grains can be performed using a known measuring device such as a laser diffraction/scattering type particle diameter distribution measuring device and a dynamic light-scattering type particle size analyzer.

The abrasive grain content in the polishing composition is preferably equal to or greater than 0.1 % by mass and more preferably equal to or greater than 1% by mass. As the abrasive grain content becomes greater, the polishing rate of an object with the polishing composition is improved.

The abrasive grain content in the polishing composition is preferably equal to or less than 50% by mass and more preferably equal to or less than 40% by mass. As the abrasive grain content becomes less, the manufacturing cost of the polishing composition is reduced and it is easy to obtain a surface having few scratches on an object after polishing with the polishing composition.

The pH of the polishing composition is preferably equal to or less than 3 and more preferably equal to or less than 1.5. By using a polishing composition having a low pH, it becomes possible to polish a compound semiconductor at a higher polishing rate.

The pH of the polishing composition can be adjusted by using various kinds of acids, bases, or salts thereof. More specifically, an organic acid (such as carboxylic acid, organic phosphonic acids, and organic sulfonic acid), an inorganic acid (such as phosphoric acid, phosphorous acid, sulfuric acid, nitric acid, hydrochloric acid, boric acid, and carbonic acid), an organic base (such as amine and quaternary ammonium hydroxide), a hydroxide of alkali metal, a hydroxide of alkali earth metal, an inorganic base (such as ammonia), or any of salts of these acids and bases is used preferably.

The present embodiment provides the following advantages.

The polishing composition of the present embodiment contains an oxidizing agent having a redox potential equal to or greater than 1.8 V at a pH for application of polishing. Accordingly, it is possible with the polishing composition of the present embodiment to perform polishing at a high polishing rate even for a hard compound semiconductor having a Vickers hardness equal to or greater than 1,500 Hv.

The embodiment may be modified as follows.
- The polishing composition of the embodiment may contain two or more types of abrasive grains selected from among silicon oxide, aluminum oxide, cerium oxide, zirconium oxide, titanium oxide, manganese oxide, silicon carbide, and silicon nitride. In addition, two or more types of surface-modified abrasive grains may be contained.
- The polishing composition of the embodiment may contain an additive having an effect of further improving the polishing rate, such as a complexing agent and an etching agent, as necessary.
- The polishing composition of the embodiment may further contain a known additive such as a preservative, a fungicide, and a rust-preventive agent as necessary.
- The polishing composition of the embodiment may further contain an additive such as a dispersing agent for improving the dispersibility of abrasive grains and a dispersion aid for facilitating redispersion of agglomerated abrasive grains as necessary.
- The polishing composition of the embodiment may be of a one-agent type or may be of a multi-agent type, such as a two-agent type, including a plurality of agents each containing a part or the whole of components in the polishing composition at an arbitrary ratio. More specifically, a first composition containing the abrasive grains and water and a second composition containing the oxidizing agent and water may be provided and mixed with each other to prepare the polishing composition. When the polishing composition further contains a pH adjuster, the pH adjuster may be contained in either the first composition or the second composition, or may be included in both of the first composition and the second composition. In the case of a polishing composition of a two-agent type, the first composition and the second composition may be supplied to a polishing device through separate paths and mixed with each other on the polishing device.
- The polishing composition of the embodiment may be prepared by diluting stock solution of the polishing composition with water. In the case of a polishing composition of a two-agent type, dilution may be performed before mixing the first composition with the second composition or may be performed after mixing. For example, any one of the first composition and the second composition may be diluted with water and then mixed with the other. Also, mixing of the first composition with the second composition may be performed simultaneously with dilution with water.
- The polishing composition after being used for polishing an object may be recovered and reused (cyclic use). In such a case, the need for treating a used polishing composition as wastes is reduced and therefore it is possible to reduce environmental loads and costs.

Next, examples of the present invention and comparative examples will be described.

### (Examples 1 to 11 and Comparative Examples 1 to 4)

Polishing compositions of Examples 1 to 11 and Comparative Examples 1 to 4 were prepared by adding an oxidizing agent to colloidal silica and diluting the mixture with water, and further adding a pH adjuster as necessary. The colloidal silica used here had an average secondary particle diameter (volume mean diameter D50) of 0.08 µm measured with a laser diffraction/scattering type particle diameter distribution measuring device "LA-950" manufactured by HORIBA, Ltd. Nitric acid was used as a pH adjuster. Polishing compositions of the respective examples were used to polish a Ga surface of a gallium nitride substrate, which is a compound semiconductor, under conditions shown in Table 1. Each gallium nitride substrate used here had a circular shape with a diameter of 2 inches.

The average secondary particle diameter and the content of colloidal silica, i.e., abrasive grains in each polishing composition, the pH of each polishing composition, and the type and the content of an oxidizing agent contained in each polishing composition are shown in Table 2. In addition, the weight of a gallium nitride substrate was measured before and after polishing using each polishing composition. The polishing rate calculated on the basis of the difference between weight before polishing and weight after polishing is illustrated in the column entitled "polishing rate" in Table 2.

**Table 1**

| |
|---|
| <Polishng Conditions for Gallium Nitride Substrate> |
| Polishing Device a single-side polishing device "EJ-380IN" (surface plate diameter of 380mm) manufactured by Engis Japan Corporation |
| Polishing Pad a nonwoven polishing pad "SUBA800" manufactured by Nitta Haas Incorporated |
| Polishing Load 300 g/cm² (29 4 kPa) |
| Surface Plate Rotational Rate 60 rpm |
| Linear Speed 45 m/min |
| Polishing Time 30 minutes |
| Feed Rate of Polishing Composition 20 mL/min (continuously fed without being circulated) |

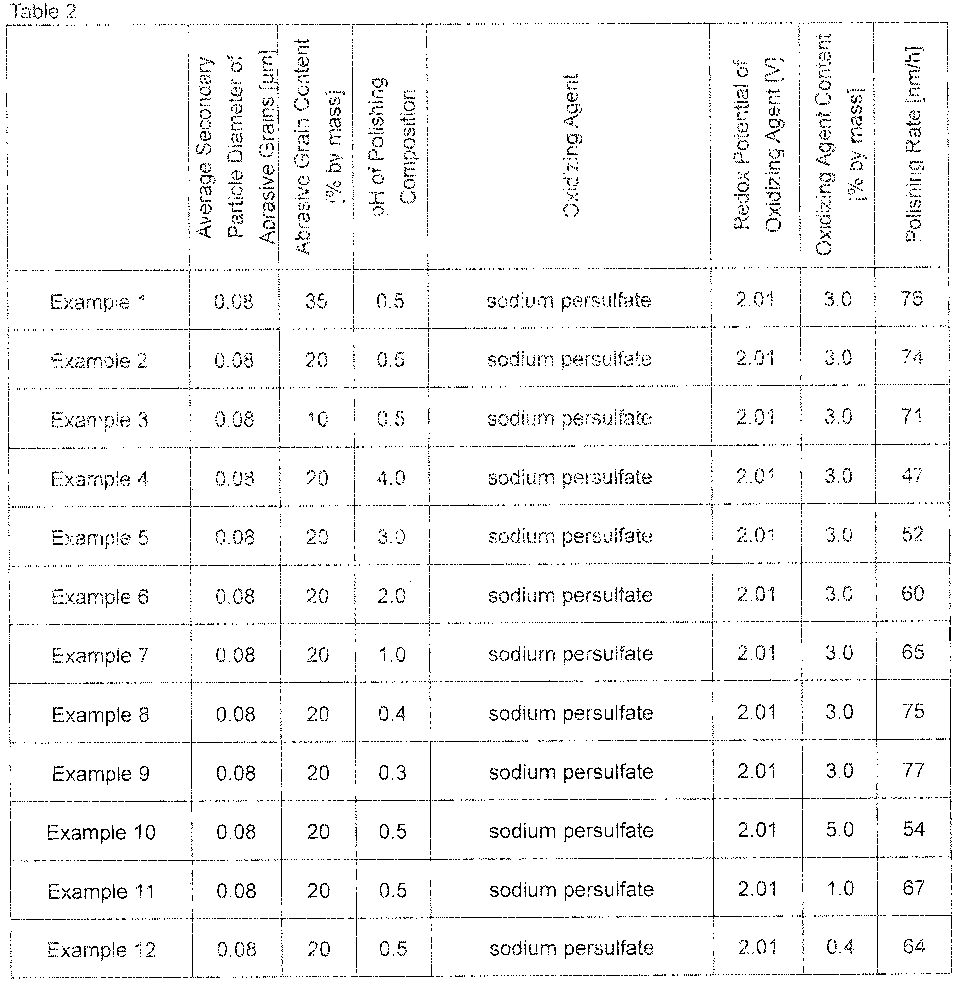

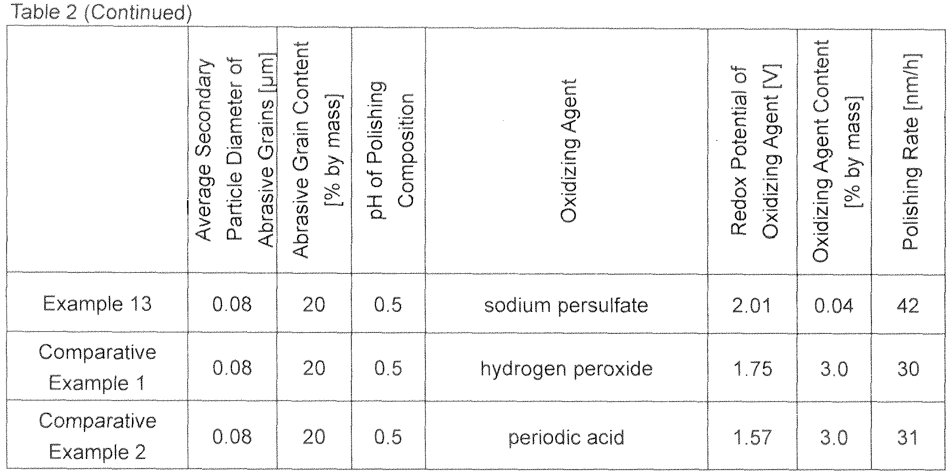

As shown in Table 2, a higher polishing rate was obtained in a case where polishing compositions of Examples 1 to 13 were used for polishing a gallium nitride substrate in comparison with the case of polishing compositions of Comparative Examples 1 and 2.

### INDUSTRIAL APPLICABILITY

According to the present invention, it is possible to polish an object made of a compound semiconductor at a high polishing rate and to increase in productivity led by improvement in polishing efficiency.

## Claims

1. A polishing composition to be used for polishing a compound semiconductor, **characterized by** containing at least:
abrasive grains;
an oxidizing agent having a redox potential equal to or greater than 1.8 V at a pH at which the polishing is carried out; and
water.

2. The polishing composition according to claim 1, wherein the oxidizing agent is composed of at least one substance selected from the group consisting of sodium persulfate, potassium persulfate, and ammonium persulfate.

3. The polishing composition according to claim 1, wherein the oxidizing agent is a hydroxy radical.

4. The polishing composition according to any one of claims 1 to 3, wherein the polishing composition has a pH equal to or less than 3.

5. The polishing composition according to any one of claims 1 to 4, wherein the abrasive grains are composed of at least one substance selected from the group consisting of silicon oxide, aluminum oxide, cerium oxide, zirconium oxide, titanium oxide, manganese oxide, silicon carbide, and silicon nitride

6. A method for preparing the polishing composition according to any one of claims 1 to 5, comprising:
providing a first composition containing abrasive grains and water and a second composition containing an oxidizing agent having a redox potential equal to or greater than 1.8 V and water; and
mixing the first composition with the second composition to prepare the polishing composition.

7. A method for polishing a compound semiconductor with the polishing composition according to any one of claims 1 to 5.

8. A manufacturing method of a compound semiconductor, comprising polishing a compound semiconductor using the method according to claim 7.
